# EUROPEAN PATENT APPLICATION

(11) **EP 1 720 270 A1**
(43) Date of publication of application: **08.11.2006**
(21) Application number: 05112796.7
(22) Date of filing: 22.12.2005
(51) Int. Cl.: H04B 10/155, H01S 5/14, G02B 6/00, H04B 10/207

(54) **Base station optical line terminal of passive optical subscriber network using wavelength division multiplexing method and method for manufacturing the same**

(30) Priority: 04.05.2005 KR 2005037756
(71) Applicant: ELECTRONICS AND TELECOMMUNICATIONS RESEARCH INSTITUTE, Daejeon 305-350 (KR)
(72) Inventor: Shin, Jang-Uk, 305-345, Daejon (KR); Park, Sang-Ho, 305-755, Daejon (KR); Kim, Duk-Jun, 302-280, Daejon (KR); Park, Yoon-Jung, 130-846, Seoul (KR); Han, Young-Tak, 302-280, Daejon (KR); Sung, Hee-Keyng, 305-761, Daejon (KR)
(74) Representative: Betten & Resch

(57) **Abstract**

A method for manufacturing a plurality of light sources is provided with a low cost to economically construct a passive optical subscriber network of a wavelength division multiplexing method using a wavelength division multiplexing and demultiplexing device. More specifically, disclosed is a method for manufacturing a plurality of light sources with a low cost applying a planar lightwave circuit (PLC) hybrid integrated technology to a PLC chip as a method for constructing a light source with a plurality of wavelengths constituting an optical transmitter of a base station to economically construct a passive optical subscriber network of a wavelength division multiplexing method. The optical transmitter constitutes a hybrid assembly comprising a plurality of semiconductor lasers, a plurality of higher order gratings and a plurality of wavelength division multiplexers.

## Description

### Field of the Invention

The present invention relates to a passive optical subscriber network of a wavelength division multiplexing method using a wavelength division multiplexing and demultiplexing device; and, more particularly, to a method for manufacturing a plurality of light sources with a low cost applying a planar lightwave circuit(PLC) hybrid integrated technology to a PLC chip as a method for constructing a light source with a plurality of wavelengths constituting an optical transmitter of a base station to economically construct a passive optical subscriber network of a wavelength division multiplexing method.

### Description of Related Art

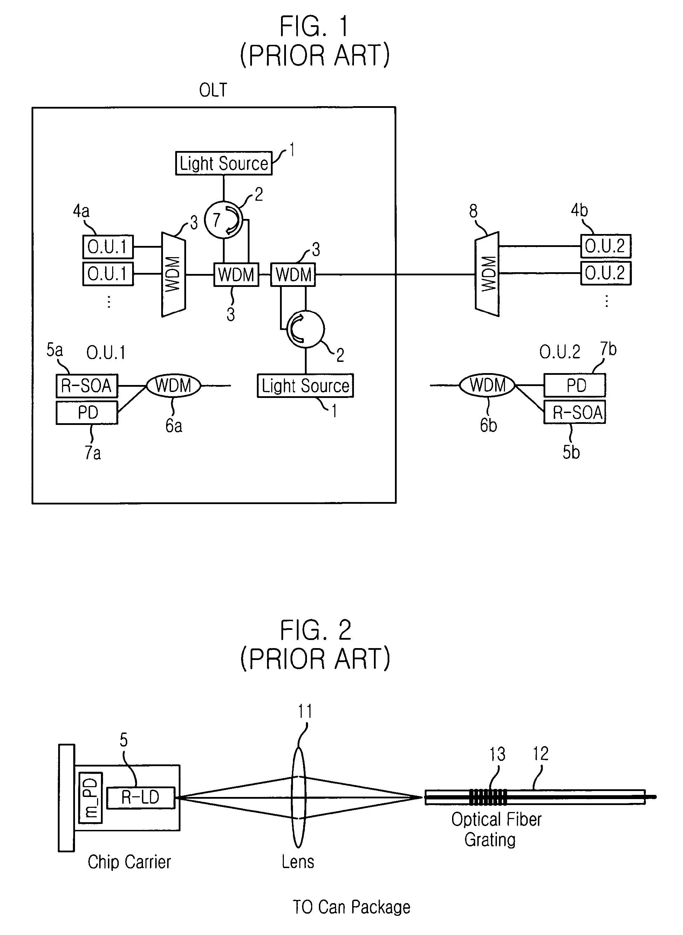

As a next generation subscriber network to make provisions for a high speed and large amount information age, it is expected that a wavelength division multiplexing passive optical subscriber network as shown in Fig. 1 will be introduced.

Fig. 1 is a schematic diagram showing a conventional passive optical subscriber network using a wavelength division multiplexing method.

Referring to Fig. 1, in the base station optical line terminal (OLT), a light generated at a base station optical bandwidth light source 1 is applied to a base station optical unit transceiver(O.U.1) 4a by dividing it into each channel wavelength through an optical circulator 2 and a wavelength division multiplexer(WDM) 3. The above-described light of intrinsic wavelength applied by each channel is amplified by a reflective semiconductor optical amplifier (R-SOA) 5a in the base station optical unit transceiver(O.U.1) 4a or a spectrum slicing method in an FP-LD or generates an optical signal with an intrinsic channel wavelength carrying the data by modulating with oscillating in a wavelength fixed FP-LD method. The generated optical signal is transmitted to the side of the subscriber again through the wavelength division multiplexer 3. Meanwhile, the optical signal transmitted from the side of subscriber is transmitted to the base station optical unit transceiver (O.U.1) 4a for each channel with passing through the wavelength division multiplexer 3 and it is received and converted into an electrical signal at the wavelength division multiplexer 6a in a photo diode(PD) 7a passing through the base station optical unit transceiver(O.U.1) 4a.

On the other hand, in the subscriber optical network unit(ONU), similar to the base station also in the subscriber optical unit transceiver(O.U.2) 4b, a light generated at a base station optical bandwidth light source 1 is applied to the subscriber optical unit transceiver(O.U.2) 4b by dividing it into each channel wavelength through the optical circulator 2 and the WDM 8 at a remote node(RN). An optical signal of an intrinsic channel wavelength carrying the data is generated by modulating and amplifying the above-described light of intrinsic wavelength applied by each channel with the R-SOA 5a in the subscriber O.U.2 4a or in an FP-LD. The above generated optical signal is transmitted to the side of base station again through the WDM 8 at the RN. On the other hand, the optical signal transmitted from the side of the base station is transmitted to the O.U.2 for each channel with passing through the WDM 8 at the RN and is received by converting into an electric signal at the PD 7b through the WDM 6b in the O.U.2.

The passive optical subscriber network of the wavelength division multiplexing method as shown in Fig. 1 supplies a large amount of information with a high speed to each of the subscribers by assigning an individual wavelength to each subscriber.

However, in spite of these advantages, the passive optical subscriber network of the wavelength division multiplexing method as shown in Fig. 1 has not been put to practical use since it is difficult to secure the economical efficiency due to the problems of a cost required to construct the network, specifically to the cost of a light source with a plurality of wavelengths. That is, since each transmitter at both sides of the base station and the subscriber per each subscriber is installed individually, the passive optical subscriber network of the wavelength division multiplexing method can have been put to practical use only if the optical transmitters at the side of the base station as well as the side of the subscriber are supplied with a low cost and a mass products. And also, in the base station, since optical transmitters for a number of subscribers are installed in all of the base stations, the size of the base station optical line terminal must be reduced in order to reduce the install space of the optical transmitter.

In case of a base station optical line terminal, since it is installed by individually constructing the optical unit(O.U.) transmitter for each subscriber(or channel), it has shortcomings that the cost of individually packaging each of the O.U. transmitter and the cost of the optical fiber wiring to connect the O.U. transmitter are very expensive as well as the efficiency is deteriorated in view of a space required for the install. Therefore, there is required for an integration technology to package simultaneously by all of optical transmitters with a plurality of wavelengths on a single substrate at the side of the optical base station using an optical waveguide hybrid integration technology as a method for implementing a low cost of a WMD passive optical subscriber network by saving the install cost and the install space of the optical transmitter in the above-described base station.

Fig. 2 is a schematic diagram illustrating an optical fiber grating type external cavity laser according to a prior art.

As shown in Fig. 2, an external cavity optical amplifier is constructed by optically connecting an optical fiber 12 engraved an optical fiber grating 13 thereinto to a reflective optical amplifier or a laser diode(LD) 5 using an optical lens 11. An optical fiber fabricating the end of the optical fiber grating into a lens can be employed without utilizing an optical lens according to the cases. Herein, an mPD is a portion to generate an upward signal to be transmitted to the OLT.

The overall external cavity laser(ECL) light source is packaged by a transistor outline-can package method. At this time, the optical fiber grating 13 engraved into the optical fiber can relatively and easily manufacture one period reflective grating with a specific wavelength using a conventional UV laser interferometer.

However, if the above-described prior art is used, the packaging cost becomes very high since the external cavity lasers for each channel are individually packaged.

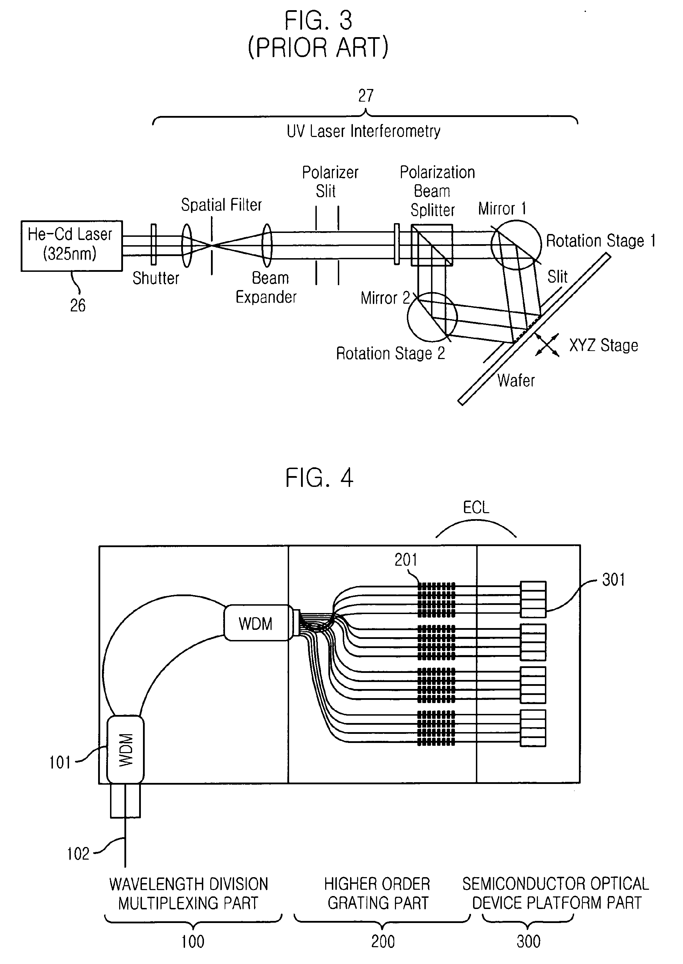

Fig. 3 is a schematic diagram showing a method for forming a grating on a planar waveguide according to a prior art.

Referring to Fig. 3, in order to engrave the reflective grating on the planar waveguide, an ultraviolet(UV) laser interferometer 27 is constructed and a grating pattern can be manufactured using a photo resist by irradiating a light of an interference pattern on a wafer formed thereon the waveguide, wherein the interference pattern is formed by interfering the light at a predetermined angle in response to a required grating period by dividing the UV laser. And also, in order to manufacture the interference pattern, an expensive phase mask may be used in place of the interferometer.

In case of the conventional technology using the above-described interferometer, since an additional UV laser 26 such as He-Cd laser and an interferometer construction using the same are required as well as the refractive index distribution of the formed grating becomes a harmonic function such as a sine wave, it is impossible that the reflective grating is manufactured by using a higher order grating except the first order grating. And also, in case of using the conventional method, in order to engrave the grating with a wavelength different from each other on each of the waveguides, since the gratings are manufactured by sequentially engraving them for each wavelength one by one, it is impossible to manufacture an effective grating when a plurality of gratings are required, therefore, a high process cost is occurred to engrave the grating.

### Summary of the Invention

The present invention has been proposed in order to overcome the above-described problems in the related art. It is, therefore, an object of the present invention to provide a low cost base station optical line terminal of a passive optical subscriber network using a wavelength division multiplexing method and a method for manufacturing the same by reducing the manufacturing cost and saving the installation space of the base station optical line terminal.

In accordance with an aspect of the present invention, there is provided a base station optical line terminal of a passive optical subscriber network using a wavelength division multiplexing method, the base station optical line terminal including a wavelength division multiplexing unit on which a plurality of wavelength division multiplexers is integrated on a planar waveguide; a higher order grating unit in which a reflective grating with a higher order period on a waveguide connected to each output waveguide of the wavelength division multiplexing unit, wherein the higher order period of the reflective grating is wider than 3 periods; and a semiconductor optical device platform unit mounted thereon a plurality of semiconductor optical device unit made of a plurality of semiconductor optical devices and constituting an external cavity laser by connecting outputs of the semiconductor optical devices to each waveguide of the higher order grating unit through an optical waveguide, wherein the wavelength division multiplexing unit, the higher order grating unit and the semiconductor optical device platform unit are hybrid-assembled on the same chip in the planar optical waveguide and an optical fiber for an optical output is attached to one end of the output waveguide of the wavelength division multiplexer of the wavelength division multiplexing unit, wherein the higher order period of the reflective grating is an odd number period wider than 3 periods in the higher order grating unit and wherein the higher order period of the reflective grating is 3 periods or 5 periods.

Preferably, the higher order reflective grating of the higher order grating unit is anyone selected among a group consisting of a hetero grating, a core grating or a clad grating.

Preferably, the hetero grating is a grating formed by a material with a refractive index different from that of the optical waveguide and formed between a waveguide core layer and an over clad layer or an under clad layer of an optical waveguide formed by stacking a silicon substrate, the under clad layer on the silicon substrate, the waveguide core layer on the under clad layer and the over clad layer on the waveguide core layer sequentially.

Preferably, the core grating is a grating formed by deforming a portion of a waveguide core layer of an optical waveguide formed by stacking a silicon substrate, an under clad layer on the silicon substrate, the waveguide core layer on the under clad layer and an over clad layer on the waveguide core layer sequentially as a grating shape.

Preferably, the clad grating is a grating formed by etching an under clad layer of an optical waveguide formed by stacking a silicon substrate, the under clad layer on the silicon substrate, a waveguide core layer on the under clad layer and an over clad layer on the waveguide core layer sequentially into a grating shape.

In accordance with another aspect of the present invention, there is provided a method for manufacturing a base station optical line terminal of a passive optical subscriber network using a wavelength division multiplexing method, the method including the steps of: integrating a plurality of wavelength division multiplexers and a higher order grating unit made of a higher order grating on a single planar optical waveguide chip; and forming a semiconductor optical device platform unit provided with a plurality of semiconductor optical devices on a predetermined portion of the planar optical waveguide chip and constituting an external cavity laser by connecting an output of the semiconductor optical device to each waveguide of the higher order grating unit through an optical waveguide.

### Brief Description of the Drawings

The above and other objects and features of the present invention will become apparent from the following description of the preferred embodiments given in conjunction with the accompanying drawings, in which:
Fig. 1 is a schematic diagram showing a conventional passive optical subscriber network using a wavelength division multiplexing method;
Fig. 2 is a schematic diagram illustrating an optical fiber grating type external cavity laser according to a prior art;
Fig. 3 is a schematic diagram showing a method for forming a grating on a planar waveguide according to a prior art;
Fig. 4 is an exemplary view depicting a hybrid integration structure of an optical transmitter in the base station in accordance with an embodiment of the present invention;
Figs. 5a to 5c are cross-sectional views illustrating a method for manufacturing a high order optical grating in accordance with another embodiment of the present invention;
Figs. 6a to 6d are cross-sectional views showing a method for manufacturing a silica optical waveguide applying the method for manufacturing the high order optical grating in accordance with the embodiment of the present invention; and
Fig. 7 is a schematic diagram representing a method for constructing a passive optical subscriber network of a wavelength division multiplexing method by applying the method for constructing the base station optical line terminal in accordance with the embodiment of the present invention.

### Detailed Description of the Invention

Hereinafter, preferred embodiments of the present invention are described in detail with respect to the accompanying drawings in such a manner that it may easily be carried out by a person having ordinary skilled in the art to which the invention pertains.

The method of the present invention is characterized in that a wavelength division multiplexer and an external cavity laser using a higher order grating are integrated into a base station optical line terminal simultaneously. And, more specifically, the present invention is characterized in that it is manufactured by a wavelength division multiplexer and a photo mask for a contact aligner generally using an optical waveguide engraved thereinto a higher order grating. Like this, by integrating the optical transmitter into a single chip together with a wavelength division multiplexer, the present invention drastically reduces a package cost and an installation space by removing an optical wiring using an optical fiber between the optical transmission module and the wavelength division multiplexer.

And also, it is a major feature of the present invention that an external cavity laser can be constructed with a simple optical waveguide device manufacturing process without an additional grating manufacturing device or a process by using a reflective grating constituting the external cavity laser as a higher order grating different from the conventional method and by using a conventional photo mask used in manufacturing an optical waveguide and a wavelength division multiplexing in place of the conventional grating manufacturing method using the required device such as a laser interferometer or an electron beam or the like during the manufacture of the conventional one period grating.

When the reflective grating is manufactured by the conventional one period grating, since the period of the grating is a half of the reflective wavelength, if the waveguide is made of silica, the grating period is approximately 0.5 µm for the wavelength having 1550 nm bandwidth. Therefore, in order to manufacture the grating having such fine period, in the conventional method the ultraviolet laser interferometer or the electron beam lithography must be used.

However, since the grating period becomes longer than the one period grating by the times of the order in case when the higher order period of the present invention is utilized, a pattern using a conventional photo mask is also available.

And also, when a high temperature process such as a silica waveguide is required, since a grating erasing phenomena is occurred at the one period grating with the fine pattern due to the diffusion phenomena in the high temperature, it is impossible to engrave the grating during the waveguide process. Therefore, after the waveguide formation of the high temperature process is finished, the ultraviolet(UV) writing method using the UV laser interferometer must be employed.

However, since the higher order grating of the present invention is designed in such a way that the grating period is longer than the diffusion distance of the waveguide material, the formation of the waveguide and the formation of the grating are simultaneously performed during the waveguide process without an additional grating manufacturing process.

And also, in the conventional method, in order to manufacture a plurality of gratings having a wavelength different from each other, each of the gratings must be sequentially manufactured one by one. Whereas the present invention provides an optimum method for manufacturing the wavelength division multiplexing optical transmitter since an arbitrary number of gratings formed on the photo mask are simultaneously manufactured in the present invention.

When the base station optical line terminal is manufactured in accordance with the present invention, since the conventional wavelength division multiplexer is integrated with the optical transmitter having a plurality of wavelengths as well as an optical fiber connection between the optical transmitter and the wavelength division multiplexer can be reduced, the present has an advantage that the packaging cost can be drastically reduced as well as the overall size of the optical transmitter further reduced in comparison with the conventional method.

Fig. 4 is an exemplary view depicting a hybrid integration structure of an optical transmitter in the base station in accordance with an embodiment of the present invention.

As shown in Fig. 4, a hybrid integration structure of a base station optical transmitter in accordance with the embodiment of the present invention roughly consists of three parts.

That is, the hybrid integration structure of a base station optical transmitter in accordance with the embodiment of the present invention includes a wavelength division multiplexing part 100 formed by integrating a pair of wavelength division multiplexers 101 on a planar waveguide device, a higher order grating part 200 connected to output waveguides for each wavelengths of the wavelength division multiplexers and provided with a plurality of higher order reflective gratings 201 having a plurality of wavelength formed on an optical waveguide and a semiconductor optical device platform part 300 consisting of an external cavity laser(ECL) together with the higher order reflective grating 201 by connecting to each waveguide of the higher order grating part 200 as a platform on which a semiconductor optical device unit 301 is formed, wherein the semiconductor optical device unit 301 consists of a plurality of reflective laser diodes(R-LDs) or a reflective semiconductor optical amplifier(R-SOA). Herein, the other end of the wavelength division multiplexer 101 is connected to an optical fiber pigtail 102.

Since in the base station optical transmitter of the present invention shown in Fig. 4, the pair of wavelength division multiplexers 101 and a plurality of external cavity laser type light sources for each wavelength are integrated on a single planar optical waveguide device, it does not require an additional packaging for each channel light source and drastically reduce the packaging cost and the install space of the base station optical transmitter.

As shown in Fig. 4, the semiconductor optical device platform part 300 constructs an optical transmitting unit by hybrid integrating the semiconductor optical device unit 301 consisting of a plurality of R-LDs or an R-SOA. The platform to mount the semiconductor optical device 301 is provided with a trench by etching a predetermined portion of the planar optical waveguide chip formed thereon the optical waveguide and is provided with a terrace to mount a chip in the trench, a metal wiring for the electrical connection, a solder for the chip connection, a solder dam to prevent the solder from flowing down and the like.

The assembly of the semiconductor optical device unit 301 is performed as follows:

At first, the device is exactly placed at a position by a conventional flip-chip bonding;

The solder is melt by heating the platform, whereby the surface of the device get wet with the melt solder; and

The optical device chip is fixed by dropping the temperature of the solder again.

The light outputted from the semiconductor optical device unit 301 is again reflected to the semiconductor optical device unit 301 by reflecting a portion of the light beam having a specific wavelength in the high order reflective gratings 201 along the optical waveguide connected to each of the semiconductor optical devices. Therefore, the ECL is constructed to oscillate the light having the specific wavelength determined by the high order reflective grating 201. After the above-described oscillated light of the specific wavelength is wavelength multiplexed by connecting to the wavelength division multiplexer 101 of the wavelength division multiplexing unit 100, the multiplexed light is outputted through the optical fiber pigtail 102 connected to the opposite side of the wavelength division multiplexing unit 100.

Meanwhile, in case of the wavelength division multiplexer 101 integrated on the planar waveguide in accordance with the embodiment of the present invention, if the connection position of the optical waveguide is changed, it is not required to control the wavelength of the wavelength division multiplexer 101 through an additional temperature control since the wavelengths for each channel can be controlled.

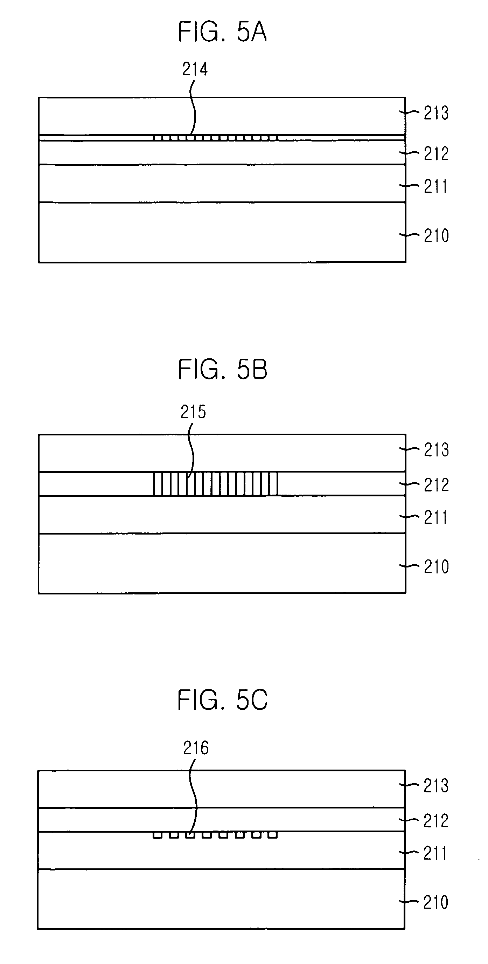

Figs. 5a to 5c are cross-sectional views illustrating a method for manufacturing a high order optical grating in accordance with another embodiment of the present invention.

As shown in Fig. 5a to 5c, a manufacturing method of a high order optical grating in accordance with the present invention are performed during a manufacturing process of an optical waveguide including the steps of forming an under clad layer 211 on a silicon substrate 210 and sequentially stacking a core layer 212 and an over clad layer 213 on the under clad layer 211. Herein, all of the under clad layer 211, the over clad layer 213 and the core layer 212 are formed with a material such as silicon dioxide(SiO₂).

The method for manufacturing the grating during the optical waveguide manufacturing process is classified into three types according to the manufacturing position of the grating.

Firstly, as shown in Fig. 5a, the grating is constructed around the optical waveguide by an additional material having a refractive index different from that of the optical waveguide, that is, a hetero grating 214 is formed between the core layer 212 and the over clad layer 213. As another method, the hetero grating 214 can be formed between the core layer 212 and the under clad layer 211.

Secondly, as shown in Fig. 5b, there is a method of optical waveguide core grating 215 to form the grating by deforming the core layer 212.

Thirdly, as shown in Fig. 5c, there is a method of clad grating 216, that is, after the grating is formed on the under clad layer 211 of the bottom of the waveguide by a method such as an etching, a core layer 212 is formed on the under clad layer 212.

The major feature of the manufacturing method of the high order grating shown in Figs. 5a to 5c is that the grating can be manufactured by using a conventional contact type alignment photo mask since the period of the grating becomes longer in proportional to the times of the order. In this case, an odd number period such as a three period, a five period, a seven period or the like is used for manufacturing the reflective grating to construct the external cavity laser. However, there is a shortcoming that the length of the grating becomes long since a reflection amount of the light becomes smaller in inverse proportion to the period in the grating as the period of the grating becomes large.

The followings are paid attentions to forming the higher order optical grating. The higher order grating is formed in such a way that the period of the grating has a size above the mask alignment accuracy of a conventional photo mask; an odd number period is selected to form the reflective grating; a low period number such as a three period or a five period is selected as possible in order to increase the reflectivity of the waveguide grating; and the period of the grating is sufficiently larger than the diffusion distance of the waveguide material when a high temperature process is perform. Therefore, the five period grating is preferable to the three period grating in the most widely used silica-based optical waveguide.

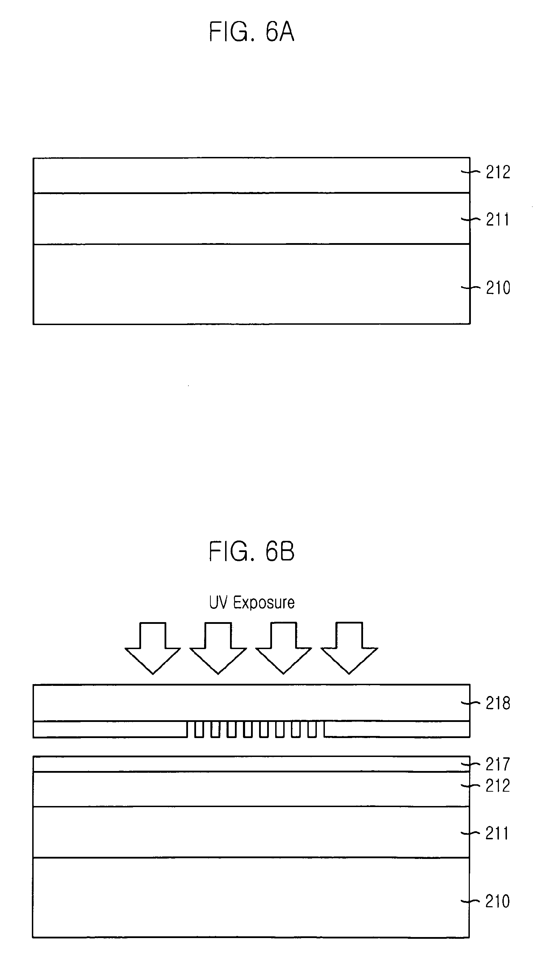

Figs. 6a to 6d are cross-sectional views showing a method for manufacturing a silica optical waveguide applying the method for manufacturing the high order optical grating in accordance with the embodiment of the present invention.

As shown in Fig. 6a, in order to manufacture the higher order grating in accordance with the embodiment of the present invention, at first, an under clad layer 211 and a waveguide core layer 212 are sequentially formed on a silicon substrate 210.

As shown in Fig. 6b, after a photo resist 217 is coated on the waveguide core layer 212 and a photo mask 218 is mounted on a top of the photo resist 217, a wavelength division multiplexing pattern, a waveguide pattern and a higher order grating pattern are transferred into the photo resist 217 by exposing an ultraviolet to the photo resist 217.

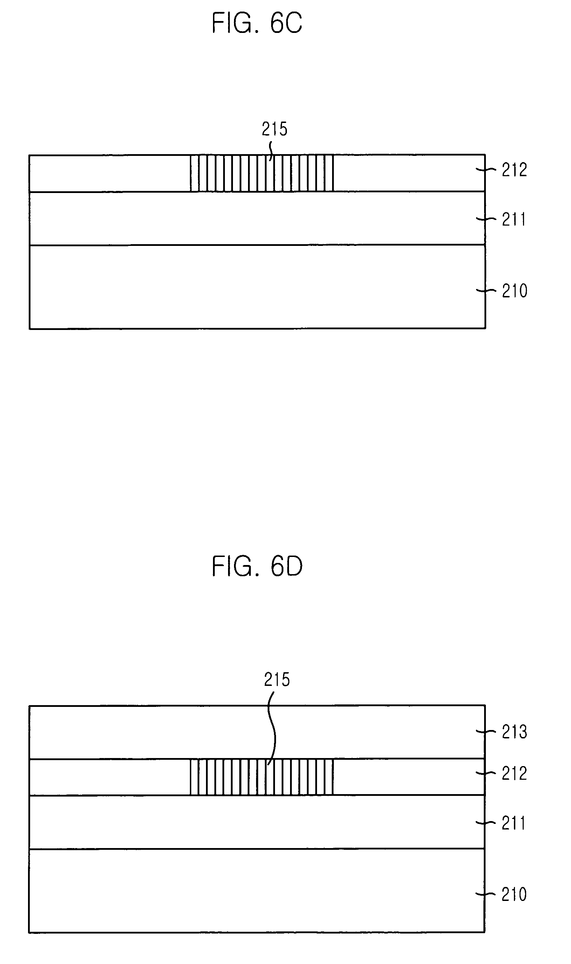

As shown in Fig. 6c, the waveguide core layer 212 is etched by using the wavelength division multiplexing pattern, the waveguide pattern and the higher order grating pattern transferred photo resist 217 as an etch mask.

A waveguide core grating 215 is formed through the etching of the waveguide core layer 212.

As shown in Fig. 6d, after the photo resist 217 is removed, the over clad layer 213 is coated on the etched waveguide core layer 212.

As described above, when the waveguide core grating 215 is manufactured using the photo mask 218, an additional process apparatus such as an ultraviolet ray interferometer or a grating manufacturing process is not required, and the manufacturing cost is drastically reduced by manufacturing the grating during the waveguide manufacturing process to manufacture the planar waveguide device. Further, since a plurality of gratings having an arbitrary wavelength at an arbitrary position on the planar waveguide are simultaneously and freely implemented by an arbitrary number, it provides an optimum method in manufacturing the wavelength division multiplexing method required to simultaneously manufacture the gratings for a plurality of wavelengths.

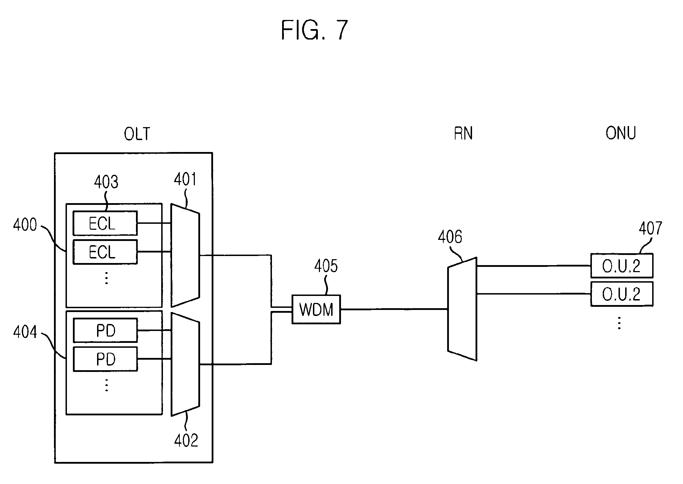

Fig. 7 is a schematic diagram representing a method for constructing a passive optical subscriber network of a wavelength division multiplexing method by applying the method for constructing the base station optical line terminal in accordance with the embodiment of the present invention.

As shown in Fig. 7, a down transmission line traveling from a base station optical line terminal(OLT) to a subscriber optical network unit(ONU) includes a light source 400 employing a plurality of external cavity lasers(ECLs) 403, a first wavelength division multiplexing multiplexer(WMUX) 401 to multiplex the outputs of the ECLS(403) of in the light source 400, a wavelength division multiplexer(WDM) 405 to multiplex the signals transmitted from the first WMUX 401, a second WMUX 406 at a remote node(RN) to de-multiplex the multiplexed signal transmitted from the WDM 405 and a subscriber optical unit transceiver(O.U.2) 407 to receive the de-multiplexed signal transmitted from the second WMUS 406 of the RN.

An upward transmission line traveling from the ONU to the OLT includes the second WMUX 406 of the RN to multiplex the upward signal for each subscriber transmitted from the subscriber ONU, the WDM 405 to multiplex the multiplexed signal transmitted from the second WMUX 406 of the RN, a third WMUX 402 of the OLT to de-multiplex the multiplexed signals from the WDM 405 and a photo diode(PD) array 404 of the OLT to receive the de-multiplexed signal from the third WMUX 402.

As shown in Fig. 7, in the base station OLT in accordance with the embodiment of the present invention, the ECL arrangement using the higher order grating is employed as the light source 400. Therefore, devices such as the external injection optical bandwidth light source 1 and the optical circulator 2 of the prior art shown in Fig. 1 are not required, thereby simply constructing the optical subscriber network.

And also, since a high quality light source of an intrinsic channel wavelength oscillated at a single mode can be secured without utilizing a high cost device such as a distributed feed-back laser diode(DFB-LD) or a distributed feed-back reflector laser diode(DBR-LD).

On the other hand, in the network structure of Fig. 7, there are required two WMUX at the side of the base station different from the prior art, it can be overcome by applying a method of integrating the light source 400 having a plurality of channels, the first WDM 401 and the third WDM 402 on a single planar lightwave circuit(PLC) chip to the present invention.

The above-described present invention has the following advantages when a subscriber ONU is manufactured for a WDM PON.

By integrating the wavelength division multiplexer on the base station OLT and the external cavity laser on the single PLC using the higher order grating simultaneously, the present invention can drastically reduce the packaging cost and the installation space by removing the optical wiring using the optical fiber between the optical transmission module and the wavelength division multiplexer.

And also, the present invention is characterized in that the external cavity laser is constructed by forming the optical waveguide formed thereon the higher order grating using the most widely used contact aligner as a photo mask. Therefore, the present invention does not require an additional grating manufacturing process using an ultraviolet ray laser interferometer or an E-beam or the like in the prior art but it can form the waveguide grating together with the optical waveguide device manufacturing process using a conventional photo mask used in manufacturing the optical wave guide and the wavelength division multiplexer. And also, although a grating removing phenomena is occurred in the one period grating of the conventional fine pattern due to the diffusion phenomena at the high temperature when the high temperature process is required such as a silica optical waveguide, the present invention can prevent the grating removing phenomena due to the diffusion of the high temperature since the grating period can be designed in such a way that it is greater than the waveguide diffusion distance.

And, in the prior art, in order to manufacture a plurality of gratings having a wavelength different from each other each grating must be sequentially manufactured by one by one. Whereas the present invention provides an optimum method for manufacturing a wavelength division multiplexing optical transceiver by allowing an arbitrary number of gratings formed on the photo mask to be formed on an arbitrary position simultaneously.

In case when the wavelength division multiplexer is integrated on the planar waveguide, since the channel wavelength of the wavelength division multiplexer can be matched to the wavelength of the grating by allowing each of the channels to be controlled when the connection position of the optical waveguide is changed, there is not required for the wavelength control of the wavelength division multiplexer through an additional temperature control or the like.

The present application contains subject matter related to Korean patent application No. 2005-0037756, filed with the Korean Patent Office on May 4, 2005, the entire contents of which being incorporated herein by reference.

While the present invention has been described with respect to certain preferred embodiments, it will be apparent to those skilled in the art that various changes and modifications may be made without departing from the scope of the invention as defined in the following claims.

## Claims

1. A base station optical line terminal of a passive optical subscriber network using a wavelength division multiplexing method, the base station optical line terminal comprising
a wavelength division multiplexing unit on which a plurality of wavelength division multiplexers is integrated on a planar waveguide;
a higher order grating unit in which a reflective grating with a higher order period on a waveguide connected to each output waveguide of the wavelength division multiplexing unit; and
a semiconductor optical device platform unit mounted thereon a plurality of semiconductor optical device units made of a plurality of semiconductor optical devices and constituting an external cavity laser by connecting outputs of the semiconductor optical devices to each waveguide of the higher order grating unit through an optical waveguide,
wherein the wavelength division multiplexing unit, the higher order grating unit and the semiconductor optical device platform unit are hybrid-assembled on the same chip in the planar optical waveguide and an optical fiber for an optical output is attached to one end of the output waveguide of the wavelength division multiplexer of the wavelength division multiplexing unit.

2. The base station optical line terminal as recited in claim 1, wherein the higher order period of the reflective grating is equal to or wider than 3 periods.

3. The base station optical line terminal as recited in claim 2, wherein the higher order period of the reflective grating is an odd number period equal to or wider than 3 periods in the higher order grating unit, preferably 3 periods or 5 periods.

4. The base station optical line terminal as recited in one of claims 1 to 3, wherein the reflective grating with the higher order is a waveguide grating formed by using a grating pattern engraved in a photo mask on which the pattern of the reflective grating is formed by a sufficiently high order so as to have a period larger than a photo mask manufacturing accuracy.

5. The base station optical line terminal as recited in one of claims 1 to 4, wherein the higher order reflective grating of the higher order grating unit is anyone selected among a group consisting of a hetero grating, a core grating or a clad grating.

6. The base station optical line terminal as recited in claim 5, wherein the hetero grating is a grating formed by a material with a refractive index different from that of the optical waveguide and formed between a waveguide core layer and an over clad layer or an under clad layer of an optical waveguide formed by stacking a silicon substrate, the under clad layer on the silicon substrate, the waveguide core layer on the under clad layer and the over clad layer on the waveguide core layer sequentially.

7. The base station optical line terminal as recited in claim 5, wherein the core grating is a grating formed by deforming a portion of a waveguide core layer of an optical waveguide formed by stacking a silicon substrate, an under clad layer on the silicon substrate, the waveguide core layer on the under clad layer and an over clad layer on the waveguide core layer sequentially as a grating shape.

8. The base station optical line terminal as recited in claim 5, wherein the clad grating is a grating formed by etching an under clad layer of an optical waveguide formed by stacking a silicon substrate, the under clad layer on the silicon substrate, a waveguide core layer on the under clad layer and an over clad layer on the waveguide core layer sequentially into a grating shape.

9. The base station optical line terminal as recited in one of claims 1 to 8, wherein an order of the reflective grating with the higher order period is selected in such a way that it is longer than a diffusion distance during a process of waveguide material among available odd orders.

10. The base station optical line terminal as recited in one of claims 1 to 9, wherein a channel wavelength of the wavelength division multiplexer is matched to a grating wavelength by adjusting a connection position of the optical output optical fiber connected to the output side of the wavelength division multiplexer.

11. A method for manufacturing a base station optical line terminal of a passive optical subscriber network using a wavelength division multiplexing method, the method comprising the steps of:
integrating a plurality of wavelength division multiplexers and a higher order grating unit made of a higher order grating on a single planar optical waveguide chip; and
forming a semiconductor optical device platform unit provided with a plurality of semiconductor optical devices on a predetermined portion of the planar optical waveguide chip and constituting an external cavity laser by connecting an output of the semiconductor optical device to each waveguide of the higher order grating unit through an optical waveguide.

12. The method as recited in claim 11, wherein the step of integrating the plurality of wavelength division multiplexers and the higher order grating unit made of the higher order grating on the single planar optical waveguide chip includes the steps of:
stacking and forming an under clad layer and a waveguide core layer on a silicon substrate;
coating a photo resist on the waveguide core layer;
transferring a wavelength division multiplexer pattern, a waveguide pattern and a higher order grating pattern on the photo resist;
forming a waveguide core grating by etching the waveguide core layer using the wavelength division multiplexer pattern, the waveguide pattern and the higher order grating pattern transferred photo resist as an etch mask;
removing the photo resist; and
coating an over clad layer on the waveguide core layer formed thereon the waveguide core grating.

13. The method as recited in claim 11 or 12, wherein the step of integrating the plurality of wavelength division multiplexers and the higher order grating unit made of the higher order grating on the single planar optical waveguide chip includes the steps of:
forming the planar optical waveguide chip as a structure sequentially stacking a silicon substrate, an under clad layer on the silicon substrate, a waveguide core layer on the under clad layer and an over clad layer on the waveguide core layer; and
forming the higher order grating unit with a material having a refractive index different from that of the optical waveguide between the waveguide core layer and the over clad layer or the under clad layer.

14. The method as recited in one of claims 11 to 13, wherein the step of integrating the plurality of wavelength division multiplexers and the higher order grating unit made of the higher order grating on the single planar optical waveguide chip includes the steps of:
forming the planar optical waveguide chip as a structure sequentially stacking a silicon substrate, an under clad layer on the silicon substrate, a waveguide core layer on the under clad layer and an over clad layer on the waveguide core layer; and
forming the higher order grating unit by etching the under clad layer into a grating shape.

15. The method as recited in one of claims 11 to 14, wherein the higher order period of the reflective grating is an odd number of period in the higher order grating unit.

16. The method as recited in claim 15, wherein the higher order period of the reflective grating is 3 periods or 5 periods.
